# EUROPEAN PATENT APPLICATION

(11) **EP 1 811 590 A2**
(43) Date of publication of application: **25.07.2007**
(21) Application number: 07250288.3
(22) Date of filing: 24.01.2007
(51) Int. Cl.: H01L 51/52

(54) **Organic light-emitting display and method of making the same**

(30) Priority: 24.01.2006 KR 20060007354; 24.03.2006 KR 20060026816
(71) Applicant: Samsung SDI Co., Ltd., Suwon-si, Gyeonggi-do (KR)
(72) Inventor: Choi, Dong-Soo, Samsung SDI Co., Ltd, Yongsin-si Gyeonggi-do (KR); Park, Jin-Woo, Samsung SDI Co., Ltd, Yongsin-si Gyeonggi-do (KR); Lim, Dae Ho, Samsung SDI Co., Ltd, Yongsin-si Gyeonggi-do (KR); Lee, Jong Woo, Samsung SDI Co., Ltd, Yongsin-si Gyeonggi-do (KR); Lee, Jae Sun, Samsung SDI Co., Ltd, Yongsin-si Gyeonggi-do (KR); Lee, Ung Soo, Samsung SDI Co., Ltd, Yongsin-si Gyeonggi-do (KR)
(74) Representative: Mounteney, Simon James

(57) **Abstract**

An organic light-emitting display device in which a substrate and an encapsulation substrate are completely sealed using a frit; and a method of preparing the same. The organic light-emitting display device includes a first substrate comprising a pixel region including an organic light-emitting diode and a non-pixel region formed in an outside of the pixel region; a second substrate combined with at least a pixel region of the first substrate; a frit provided between the non-pixel region of the first substrate and the second substrate to attach the substrate and the encapsulation substrate to each other; and a supplement material composed of resin formed in at least one region of each outer surface of the first substrate, the second substrate and the frit.

## Description

### BACKGROUND OF THE INVENTION

### 1. Field of the Invention

The present invention relates to an organic light-emitting display device and a method of making the same, and more particularly to packaging of an organic light-emitting display device.

### 2. Description of the Related Technology

An organic light-emitting display device is a type of flat panel display. The organic light-emitting display device typically includes an organic light-emitting layer arranged between facing electrodes. When a voltage is applied to the electrodes, electrons are injected from one electrode and holes are injected from the other electrode. The electrons and holes bind with each other in the organic light-emitting layer and form excitons. The excitons bring luminescent molecules of the light-emitting layer to an exited state. The luminescent molecules emit light when returning to a ground state.

Such organic light-emitting display devices have drawn attention as a next-generation display since they have an excellent image quality. In addition, they may be manufactured with a light weight and thin shape. They may also be driven at a low voltage.

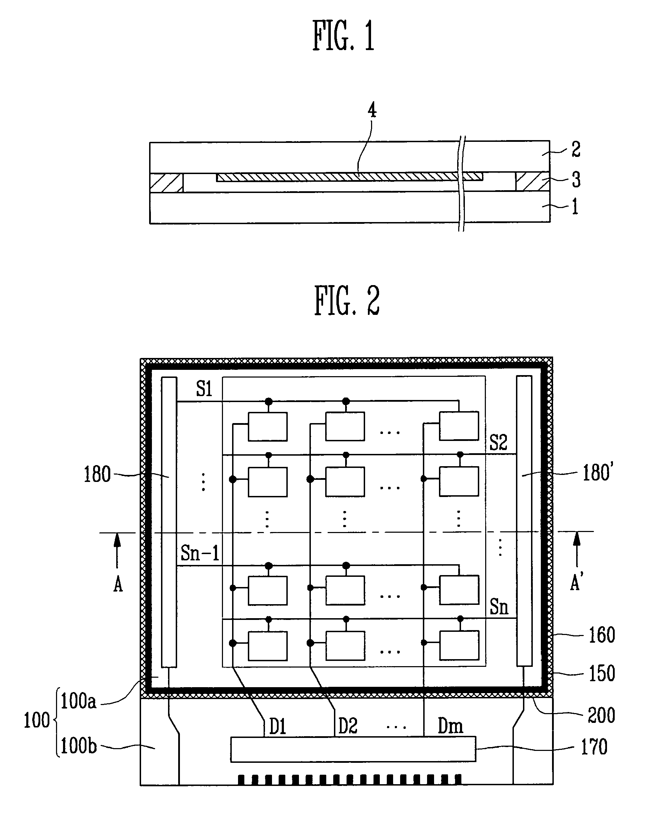

One of the problems of the organic light-emitting display device is that the organic light-emitting diode can deteriorate when moisture infiltrates into organic materials constituting the organic light-emitting diode. FIG. 1 is a cross-sectional view showing an encapsulation structure of an organic light-emitting diode intended to solve such a problem.

The organic light-emitting display device includes a deposition substrate 1, an encapsulation substrate 2, a sealing material 3 and a moisture-absorbing material 4. The deposition substrate 1 includes a pixel region including at least one organic light-emitting diode, and a non-pixel region surrounding the pixel region. The encapsulation substrate 2 is attached to a surface of the deposition substrate 1 over which an organic light-emitting diode is formed.

In order to attach the deposition substrate 1 to the encapsulation substrate 2, the sealing material 3 is applied along edges of the deposition substrate 1 and the encapsulation substrate 2. The sealing material 3 is then cured using UV irradiation or heating. The moisture-absorbing material 4 may also be included in the encapsulation substrate 2. The moisture-adsorbing material 4 removes hydrogen, oxygen, and moisture which may infiltrate between fine gaps between the sealing material 3 and the substrates 1 and 2.

In the organic light-emitting display device described above, however, the sealing material 3 cannot completely prevent infiltration of moisture. In addition, the moisture-absorbing material 4 needs to be subjected to a sintering process, which may cause outgassing. The outgassing may degrade adhesion between the sealing material 3 and the substrates. This problem may cause the organic light-emitting diode to be exposed to moisture.

U.S. Patent Application Publication No. 20040207314 discloses that an organic light-emitting diode may be sealed by coating a glass substrate with a frit without a moisture-absorbing material. According to the publication, a moisture absorbing agent need not be used and an organic light-emitting diode may be more effectively protected since an interface between a substrate and an encapsulation substrate are completely sealed by curing the melted frit.

However, even if the interface is sealed by the frit, a stress concentration phenomenon occurs on an adhesive surface between the frit and the substrate when an external impact is applied to the substrate. Therefore, cracks may be generated on the adhesive surface and spread to the entire substrate due to brittleness of the glass material.

### SUMMARY OF CERTAIN INVENTIVE ASPECTS

The present invention sets out to solve the above problems and provides an organic light-emitting device as set out in claim 1 and a method of manufacturing an organic light-emitting device as set out in claim 15. Preferred features of the invention are set out in claims 12 to 14 and 16 to 23.

### BRIEF DESCRIPTION OF THE DRAWINGS

Embodiments of the invention will now be described by way of example and with reference to the accompanying drawings in which:

FIG. 1 is a cross-sectional view showing an organic light-emitting display device according to one approach;

FIG. 2 is a top plan view of an organic light-emitting display device according to one embodiment;

FIG. 3 is a cross-sectional view of the organic light-emitting display device of FIG. 2, taken along the line A-A' of FIG. 2;

FIGS. 4A to 4H are cross-sections illustrating a process for preparing an organic light-emitting display device according to the invention;

FIG. 5A is a schematic exploded view of a passive matrix type organic light emitting display device;

FIG 5B is a schematic exploded view of an active matrix type organic light emitting display device;

FIG. 5C is a schematic top plan view of an organic light emitting display;

FIG. 5D is a cross-sectional view of the organic light emitting display of FIG. 5C, taken along the line d-d; and

FIG. 5E is a schematic perspective view illustrating mass production of organic light emitting devices.

### DETAILED DESCRIPTION

Hereinafter, embodiments according to the invention will be described with reference to the accompanying drawings. In the drawings, like reference numerals indicate identical or functionally similar elements.

An organic light emitting display (OLED) is a display device comprising an array of organic light emitting diodes. Organic light emitting diodes are solid state devices which include an organic material and are adapted to generate and emit light when appropriate electrical potentials are applied.

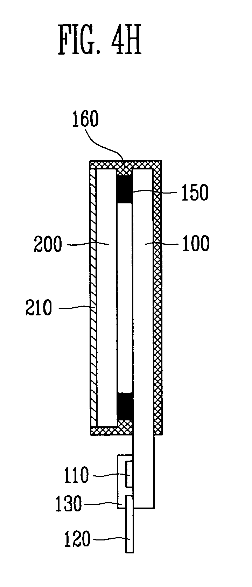

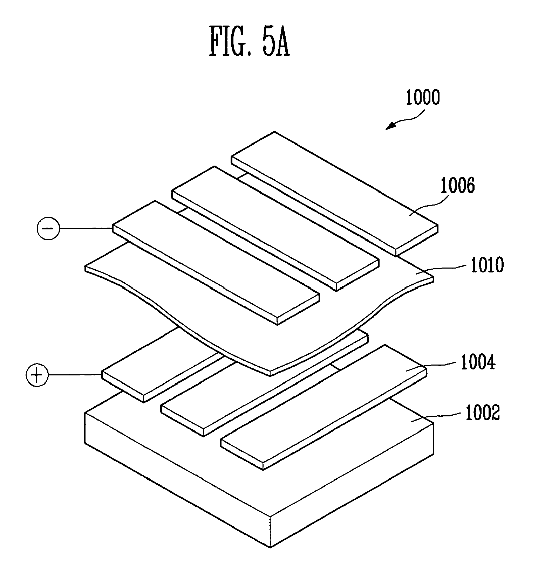

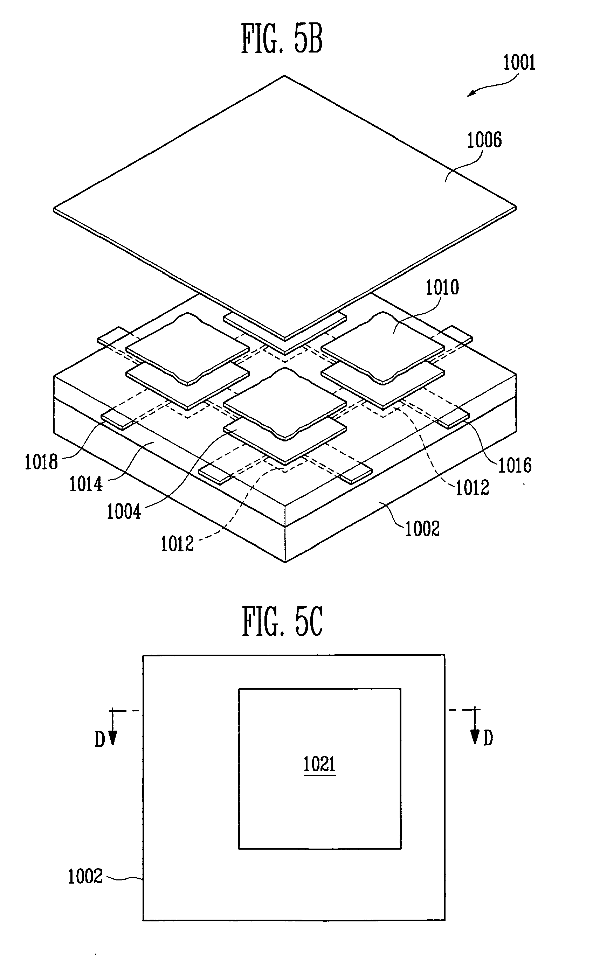

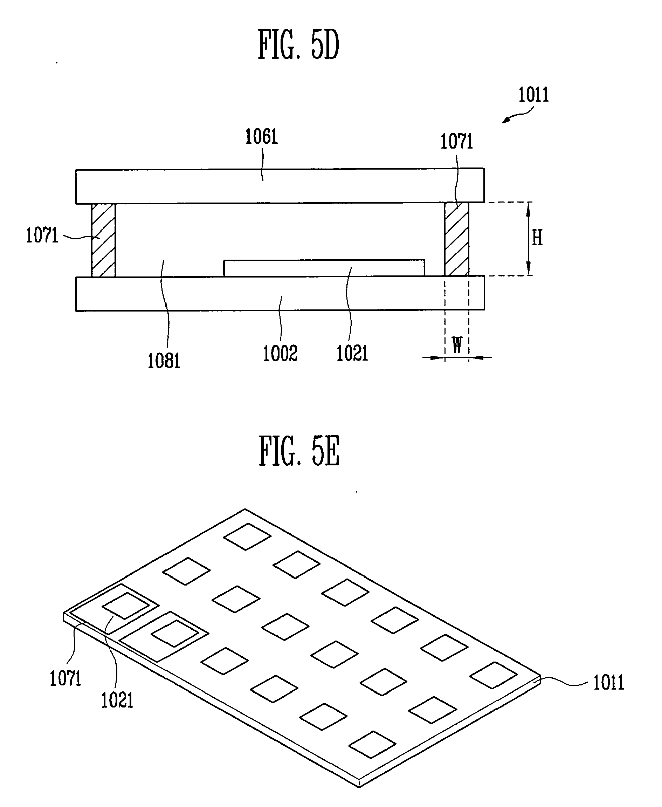

OLEDs can be generally grouped into two basic types dependent on the arrangement with which the stimulating electrical current is provided. Fig. 5A schematically illustrates an exploded view of a simplified structure of a passive matrix type OLED 1000. Fig. 5B schematically illustrates a simplified structure of an active matrix type OLED 1001. In both configurations, the OLED 1000, 1001 includes OLED pixels built over a substrate 1002, and the OLED pixels include an anode 1004, a cathode 1006 and an organic layer 1010. When an appropriate electrical current is applied to the anode 1004, electric current flows through the pixels and visible light is emitted from the organic layer.

Referring to Fig. 5A, the passive matrix OLED (PMOLED) design includes elongate strips of anode 1004 arranged generally perpendicular to elongate strips of cathode 1006 with organic layers interposed therebetween. The intersections of the strips of cathode 1006 and anode 1004 define individual OLED pixels where light is generated and emitted upon appropriate excitation of the corresponding strips of anode 1004 and cathode 1006. PMOLEDs provide the advantage of relatively simple fabrication.

Referring to Fig. 5B, the active matrix OLED (AMOLED) includes localdriving circuits 1012 arranged between the substrate 1002 and an array of OLED pixels. An individual pixel of AMOLEDs is defined between the common cathode 1006 and an anode 1004, which is electrically isolated from other anodes. Each driving circuit 1012 is coupled with an anode 1004 of the OLED pixels and further coupled with a data line 1016 and a scan line 1018. The scan lines 1018 supply scan signals that select rows of the driving circuits, and the data lines 1016 supply data signals for particular driving circuits. The data signals and scan signals stimulate the local driving circuits 1012, which excite the anodes 1004 so as to emit light from their corresponding pixels.

In the illustrated AMOLED, the local driving circuits 1012, the data lines 1016 and scan lines 1018 are buried in a planarization layer 1014, which is interposed between the pixel array and the substrate 1002. The planarization layer 1014 provides a planar top surface on which the organic light emitting pixel array is formed. The planarization layer 1014 may be formed of organic or inorganic materials, and formed of two or more layers although shown as a single layer. The local driving circuits 1012 are typically formed with thin film transistors (TFT) and arranged in a grid or array under the OLED pixel array. The local driving circuits 1012 may be at least partly made of organic materials, including organic TFT. AMOLEDs have the advantage of fast response time improving their desirability for use in displaying data signals. Also, AMOLEDs have the advantages of consuming less power than passive matrix OLEDs.

Referring to common features of the PMOLED and AMOLED designs, the substrate 1002 provides structural support for the OLED pixels and circuits. In various configurations, the substrate 1002 can comprise rigid or flexible materials as well as opaque or transparent materials, such as plastic, glass, and/or foil. As noted above, each OLED pixel or diode is formed with the anode 1004, cathode 1006 and organic layer 1010 interposed therebetween. When an appropriate electrical current is applied to the anode 1004, the cathode 1006 injects electrons and the anode 1004 injects holes. In cases embodiments, the anode 1004 and cathode 1006 are inverted; i.e., the cathode is formed on the substrate 1002 and the anode is opposingly arranged.

Interposed between the cathode 1006 and anode 1004 are one or more organic layers. More specifically, at least one emissive or light emitting layer is interposed between the cathode 1006 and anode 1004. The light emitting layer may comprise one or more light emitting organic compounds. Typically, the light emitting layer is configured to emit visible light in a single color such as blue, green, red or white. In the illustrated example one organic layer 1010 is formed between the cathode 1006 and anode 1004 and acts as a light emitting layer. Additional layers, which can be formed between the anode 1004 and cathode 1006, can include a hole transporting layer, a hole injection layer, an electron transporting layer and an electron injection layer.

Hole transporting and/or injection layers can be interposed between the light emitting layer 1010 and the anode 1004. Electron transporting and/or injecting layers can be interposed between the cathode 1006 and the light emitting layer 1010. The electron injection layer facilitates injection of electrons from the cathode 1006 toward the light emitting layer 1010 by reducing the work function for injecting electrons from the cathode 1006. Similarly, the hole injection layer facilitates injection of holes from the anode 1004 toward the light emitting layer 1010. The hole and electron transporting layers facilitate movement of the carriers injected from the respective electrodes toward the light emitting layer.

In some cases, a single layer may serve both electron injection and transportation functions or both hole injection and transportation functions. In some structures, one or more of these layers are lacking. In some arrangements, one or more organic layers are doped with one or more materials that help injection and/or transportation of the carriers. In examples where only one organic layer is formed between the cathode and anode, the organic layer may include not only an organic light emitting compound but also certain functional materials that help injection or transportation of carriers within that layer.

There are numerous organic materials that have been developed for use in these layers including the light emitting layer. Also, numerous other organic materials for use in these layers are being developed. In some cases, these organic materials may be macromolecules including oligomers and polymers. In some cases, the organic materials for these layers may be relatively small molecules. The skilled artisan will be able to select appropriate materials for each of these layers in view of the desired functions of the individual layers and the materials for the neighboring layers in particular designs.

In operation, an electrical circuit provides appropriate potential between the cathode 1006 and anode 1004. This results in an electrical current flowing from the anode 1004 to the cathode 1006 via the interposed organic layer(s). In one case, the cathode 1006 provides electrons to the adjacent organic layer 1010. The anode 1004 injects holes to the organic layer 1010. The holes and electrons recombine in the organic layer 1010 and generate energy particles called "excitons." The excitons transfer their energy to the organic light emitting material in the organic layer 1010, and the energy is used to emit visible light from the organic light emitting material. The spectral characteristics of light generated and emitted by the OLED 1000, 1001 depend on the nature and composition of organic molecules in the organic layer(s). The composition of the one or more organic layers can be selected to suit the needs of a particular application by one of ordinary skill in the art.

OLED devices can also be categorized based on the direction of the light emission. In one type referred to as "top emission" type, OLED devices emit light and display images through the cathode or top electrode 1006. In these structures, the cathode 1006 is made of a material transparent or at least partially transparent with respect to visible light. In certain cases, to avoid losing any light that can pass through the anode or bottom electrode 1004, the anode may be made of a material substantially reflective of the visible light. A second type of OLED devices emits light through the anode or bottom electrode 1004 and is called "bottom emission" type. In the bottom emission type OLED devices, the anode 1004 is made of a material which is at least partially transparent with respect to visible light. Often, in bottom emission type OLED devices, the cathode 1006 is made of a material substantially reflective of the visible light. A third type of OLED devices emits light in two directions, e.g. through both anode 1004 and cathode 1006. Depending upon the direction(s) of the light emission, the substrate may be formed of a material which is transparent, opaque or reflective of visible light.

In many cases, an OLED pixel array 1021 comprising a plurality of organic light emitting pixels is arranged over a substrate 1002 as shown in Fig. 5C. The pixels in the array 1021 are controlled to be turned on and off by a driving circuit (not shown), and the plurality of the pixels as a whole displays information or image on the array 1021. In certaincases, the OLED pixel array 1021 is arranged with respect to other components, such as drive and control electronics to define a display region and a non-display region. In thesestructures, the display region refers to the area of the substrate 1002 where OLED pixel array 1021 is formed. The non-display region refers to the remaining areas of the substrate 1002. The non-display region can contain logic and/or power supply circuitry. It will be understood that there will be at least portions of control/drive circuit elements arranged within the display region. For example, in PMOLEDs, conductive components will extend into the display region to provide appropriate potential to the anode and cathodes. In AMOLEDs, local driving circuits and data/scan lines coupled with the driving circuits will extend into the display region to drive and control the individual pixels of the AMOLEDs.

One design and fabrication consideration in OLED devices is that certain organic material layers of OLED devices can suffer damage or accelerated deterioration from exposure to water, oxygen or other harmful gases. Accordingly, it is generally understood that OLED devices be sealed or encapsulated to inhibit exposure to moisture and oxygen or other harmful gases found in a manufacturing or operational environment. Fig. 5D schematically illustrates a cross-section of an encapsulated OLED device 1011 having a layout of Fig. 5C and taken along the line d-d of Fig. 5C. In this device, a generally planar top plate or substrate 1061 engages with a seal 1071 which further engages with a bottom plate or substrate 1002 to enclose or encapsulate the OLED pixel array 1021. In other structures, one or more layers are formed on the top plate 1061 or bottom plate 1002, and the seal 1071 is coupled with the bottom or top substrate 1002, 1061 via such a layer. In the illustrated device, the seal 1071 extends along the periphery of the OLED pixel array 1021 or the bottom or top plate 1002, 1061.

The seal 1071 is made of a frit material as will be further discussed below. The top and bottom plates 1061, 1002 comprise materials such as plastics, glass and/or metal foils which can provide a barrier to passage of oxygen and/or water to thereby protect the OLED pixel array 1021 from exposure to these substances. At least one of the top plate 1061 and the bottom plate 1002 are formed of a substantially transparent material.

To lengthen the life time of OLED devices 1011, it is generally desired that seal 1071 and the top and bottom plates 1061, 1002 provide a substantially non-permeable seal to oxygen and water vapor and provide a substantially hermetically enclosed space 1081. In certain applications, it is indicated that the seal 1071 of a frit material in combination with the top and bottom plates 1061, 1002 provide a barrier to oxygen of less than approximately 10⁻³ cc/m²-day and to water of less than 10⁻⁶ g/m²-day. Given that some oxygen and moisture can permeate into the enclosed space 1081, in some devices, a material that can take up oxygen and/or moisture is formed within the enclosed space 1081.

The seal 1071 has a width W, which is its thickness in a direction parallel to a surface of the top or bottom substrate 1061, 1002 as shown in Fig. 5D. The width varies among devices and ranges from about 300 µm to about 3000 µm, optionally from about 500 µm to about 1500 µm. Also, the width may vary at different positions of the seal 1071. In some cases, the width of the seal 1071 may be the largest where the seal 1071 contacts one of the bottom and top substrate 1002, 1061 or a layer formed thereon. The width may be the smallest where the seal 1071 contacts the other. The width variation in a single cross-section of the seal 1071 relates to the cross-sectional shape of the seal 1071 and other design parameters.

The seal 1071 has a height H, which is its thickness in a direction perpendicular to a surface of the top or bottom substrate 1061, 1002 as shown in Fig. 5D. The height varies among embodiments and ranges from about 2 µm to about 30 µm, optionally from about 10 µm to about 15 µm. Generally, the height does not significantly vary at different positions of the seal 1071. However, in certain cases, the height of the seal 1071 may vary at different positions thereof.

In the illustrated device, the seal 1071 has a generally rectangular cross-section. In other structures, however, the seal 1071 can have other various cross-sectional shapes such as a generally square cross-section, a generally trapezoidal cross-section, a cross-section with one or more rounded edges, or other configuration as indicated by the needs of a given application. To improve hermeticity, it is generally desired to increase the interfacial area where the seal 1071 directly contacts the bottom or top substrate 1002, 1061 or a layer formed thereon. In some arrangements, the shape of the seal can be designed such that the interfacial area can be increased.

The seal 1071 can be arranged immediately adjacent the OLED array 1021, and in other cases, the seal 1071 is spaced some distance from the OLED array 1021. The seal 1071 comprises generally linear segments that are connected together to surround the OLED array 1021. Such linear segments of the seal 1071 can extend, in certain cases, generally parallel to respective boundaries of the OLED array 1021. In other devices one or more of the linear segments of the seal 1071 are arranged in a non-parallel relationship with respective boundaries of the OLED array 1021. In yet other devices, at least part of the seal 1071 extends between the top plate 1061 and bottom plate 1002 in a curvilinear manner.

As noted above, in certain structures, the seal 1071 is formed using a frit material or simply "frit" or glass frit," which includes fine glass particles. The frit particles includes one or more of magnesium oxide (MgO), calcium oxide (CaO), barium oxide (BaO), lithium oxide (Li₂O), sodium oxide (Na₂O) potassium oxide (K₂O), boron oxide (B₂O₃), vanadium oxide (V₂O₅), zinc oxide (ZnO), tellurium oxide (TeO₂) aluminum oxide (Al₂O₃), silicon dioxide (SiO₂), lead oxide (PbO), tin oxide (SnO), phosphorous oxide (P₂O₅), ruthenium oxide (Ru₂O), rubidium oxide (Rb₂O), rhodium oxide (Rh₂O), ferrite oxide (Fe₂O₃), copper oxide (CuO), titanium oxide (TiO₂), tungsten oxide (WO₃), bismuth oxide (Bi₂O₃), antimony oxide (Sb₂O₃), lead-borate glass, tin-phosphate glass, vanadate glass, and borosilicate, etc. Typically, these particles range in size from about 2 µm to about 30 µm, optionally about 5 µm to about 10 µm, although not limited only thereto. The particles can be as large as about the distance between the top and bottom substrates 1061, 1002 or any layers formed on these substrates where the frit seal 1071 contacts.

The frit material used to form the seal 1071 can also include one or more filler or additive materials. The filler or additive materials can be provided to adjust an overall thermal expansion characteristic of the seal 1071 and/or to adjust the absorption characteristics of the seal 1071 for selected frequencies of incident radiant energy. The filler or additive material(s) can also include inversion and/or additive fillers to adjust a coefficient of thermal expansion of the frit. For example, the filler or additive materials can include transition metals, such as chromium (Cr), iron (Fe), manganese (Mn), cobalt (Co), copper (Cu), and/or vanadium. Additional materials for the filler or additives include ZnSiO₄, PbTiO₃, ZrO₂, eucryptite.

Typically, a frit material as a dry composition contains glass particles from about 20 to 90 about wt%, and the remainder includes fillers and/or additives. In some cases, the frit paste contains about 10-30 wt% organic materials and about 70-90% inorganic materials. In some embodiments, the frit paste contains about 20 wt% organic materials and about 80 wt% inorganic materials. In some cases, the organic materials may include about 0-30 wt% binder(s) and about 70-100 wt% solvent(s). In some cases, about 10 wt% is binder(s) and about 90 wt% is solvent(s) among the organic materials. In some cases, the inorganic materials may include about 0-10 wt% additives, about 20-40 wt% fillers and about 50-80 wt% glass powder. In somecases, about 0-5 wt% is additive(s), about 25-30 wt% is filler(s) and about 65-75 wt% is the glass powder among the inorganic materials.

In forming a frit seal, a liquid material is added to the dry frit material to form a frit paste. Any organic or inorganic solvent with or without additives can be used as the liquid material. Typically, the solvent includes one or more organic compounds. For example, applicable organic compounds are ethyl cellulose, nitro cellulose, hydroxyl propyl cellulose, butyl carbitol acetate, terpineol, butyl cellusolve, acrylate compounds. Then, the thus formed frit paste can be applied to form a shape of the seal 1071 on the top and/or bottom plate 1061, 1002.

In onecase, a shape of the seal 1071 is initially formed from the frit paste and interposed between the top plate 1061 and the bottom plate 1002. The seal 1071 can in certain cases be pre-cured or pre-sintered to one of the top plate and bottom plate 1061, 1002. Following assembly of the top plate 1061 and the bottom plate 1002 with the seal 1071 interposed therebetween, portions of the seal 1071 are selectively heated such that the frit material forming the seal 1071 at least partially melts. The seal 1071 is then allowed to resolidify to form a secure joint between the top plate 1061 and the bottom plate 1002 to thereby inhibit exposure of the enclosed OLED pixel array 1021 to oxygen or water.

The selective heating of the frit seal is carried out by irradiation of light, such as a laser or directed infrared lamp. As previously noted, the frit material forming the seal 1071 can be combined with one or more additives or filler such as species selected for improved absorption of the irradiated light to facilitate heating and melting of the frit material to form the seal 1071.

In some cases, OLED devices 1011 are mass produced. In an embodiment illustrated in Fig. 5E, a plurality of separate OLED arrays 1021 is formed on a common bottom substrate 1101. In the illustratedexample, each OLED array 1021 is surrounded by a shaped frit to form the seal 1071. A common top substrate (not shown) is placed over the common bottom substrate 1101 and the structures formed thereon such that the OLED arrays 1021 and the shaped frit paste are interposed between the common bottom substrate 1101 and the common top substrate. The OLED arrays 1021 are encapsulated and sealed, such as via the previously described enclosure process for a single OLED display device. The resulting product includes a plurality of OLED devices kept together by the common bottom and top substrates. Then, the resulting product is cut into a plurality of pieces, each of which constitutes an OLED device 1011 of Fig. 5D. In certain cases, the individual OLED devices 1011 then further undergo additional packaging operations to further improve the sealing formed by the frit seal 1071 and the top and bottom substrates 1061, 1002.

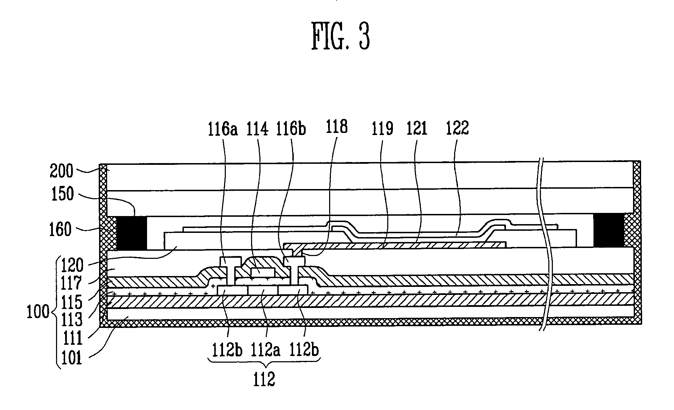

FIG. 2 is a plan view showing an organic light-emitting display device according to one embodiment of the invention. FIG. 3 is a plan view taken along the line A-A' of FIG. 2. Referring to the figures, the organic light-emitting display device includes a substrate 100, an encapsulation substrate 200, a frit 150 and a supplement material 160. For convenience of the description, the substrate 100 may refer to a substrate including an organic light-emitting diode. The deposition substrate 101 may refer to a substrate that serves as a base over which the organic light-emitting diode is formed. Accordingly, in the context of this document, the substrate 100 and the deposition substrate 101 may be distinguished from each other unless otherwise indicated.

The substrate 100 is a plate including an organic light-emitting diode. The substrate 100 may include a pixel region 100a and a non-pixel region 100b surrounding the pixel region 100a. The pixel region 100a includes a plurality of organic light-emitting diodes. Each organic light-emitting diode may include a first electrode 119, an organic layer 121 and a second electrode 122. The pixel region 100a is configured to display an image using light emitted from the plurality of organic light-emitting diodes. The non-pixel region 100b may provide space for circuits for driving the organic light-emitting diodes.

The pixel region 100a includes a plurality of scan lines (S1 to Sm) arranged in a horizontal direction, and a plurality of data lines (D1 to Dm) arranged in a vertical direction. A plurality of pixels are formed at intersections of the scan lines (S 1 to Sm) and the data lines (D 1 to Dm). The pixels receive signals from a driver integrated circuit 300 for driving the organic light-emitting diodes.

The non-pixel region 101b includes the driver integrated circuit (Driver IC) for driving the organic light-emitting diodes. The non-pixel region 101b also includes metallic wirings electrically connected to the scan lines (S1 to Sm) and the data lines (D1 to Dm) of the pixel region. In this embodiment, the driver integrated circuit includes a data driving unit 170 and scan driving units 180, 180'. The illustrated organic light-emitting diode is driven by an active matrix method. Its configuration will be briefly described below.

A buffer layer 111 is formed on a base substrate 101. The buffer layer 111 may be formed of insulating materials such as silicon dioxide (SiO₂) and/or silicon nitride (SiNx). The buffer layer 111 prevents the substrate 100 from being damaged by factors such as heat from the outside.

Over at least a portion of the buffer layer 111 is formed a semiconductor layer 112. The semiconductor layer 112 includes an active layer 112a and an ohmic contact layer 112b. On the semiconductor layer 112 and the buffer layer 111 is formed a gate insulating layer 113. On a portion of the gate insulating layer 113 is formed a gate electrode 114. At least a portion of the gate electrode 114 vertically overlaps with the active layer 112a.

An interlayer insulating layer 115 covers the gate electrode 114. The interlayer insulating layer 115 is formed on the gate insulating layer 113. Source and drain electrodes 116a, 116b are formed on portions of the interlayer insulating layer 115 above the ohmic contact layer 112b.

The source and drain electrodes 116a and 116b contact with the ohmic contact layer 112b. An overcoat 117 covers the source and drain electrodes 116a and 116b. The overcoat 117 is also formed on the interlayer insulating layer 115.

A first electrode 119 is formed on a portion of the overcoat 117. The first electrode 119 is connected to one of the source and drain electrodes 116a,116b through a via hole 118.

A pixel definition layer 120 is formed over the overcoat 117, covering side portions of the first electrode 119. The pixel definition layer 120 is patterned to have an opening (not shown) to expose at least a portion of the first electrode 119.

An organic layer 121 is formed in the opening of the pixel definition layer 120. The organic layer 121 contacts with the exposed portion of the first electrode 119. A second electrode layer 122 is formed over the organic layer 121 and the pixel definition layer 120. A passivation layer may be further formed over an upper surface of the second electrode layer 122. A skilled artisan will appreciate that various modifications and changes may be made in an active or passive matrix structure of the organic light-emitting diode.

An encapsulation substrate 200 is a member for encapsulating at least one pixel region 100a of the substrate in which the organic light-emitting diode is formed. In one embodiment for a top emission type device, the encapsulation substrate 200 may be formed of a transparent material, for example, glass. In another embodiment for a bottom emission type device, the encapsulation substrate 200 may be formed of translucent materials. A skilled artisan will appreciate that various other materials may be used for the encapsulation substrate 200, depending on the design of a device.

The illustrated encapsulation substrate 200 has a plate shape. The encapsulation substrate 200 encloses the pixel region. The substantially entire portion of the substrate 100 is encapsulated except a data driving unit and a pad unit in this embodiment.

The frit 150 is formed between the encapsulation substrate 200 and the non-pixel region 100b of the substrate 100. The frit 150 seals the pixel region 100a so that air, moisture or other impurities is prevented from being infiltrated. The term, "frit," as used herein, may refer to either a powdery glass material including additives or a glass formed by melting a frit. Accordingly, a "frit" is used to mean either type of the glasses in the context of this document.

The frit 150 forms a line spaced apart at a constant distance from an edge of an interface in which the encapsulation substrate 200 and the substrate 100 address each other. This is to provide a space for a supplement material 160, as will be described later.

The frit 150 may include a material for absorbing a laser and a filler for reducing a thermal expansion coefficient. For example, the frit is a mixture of two or more selected from the group consisting of K₂O, Fe₂O₃, Sb₂O₃, ZnO, P₂O₅, V₂O₅, TiO₂, Al₂O₃, B₂O₃, WO₃, SnO, and PbO. The frit may be applied to the encapsulation substrate 200 in a form of frit paste. Then, the encapsulation substrate 200 is aligned with the substrate 100 with the frit interposed therebetween. The frit may be melted and cured using a laser or an infrared ray. The frit seals the space between the encapsulation substrate 200 and the substrate 100.

The frit 150 has a width of from about 0.5 to about 1.5 mm. The frit 150 has a thickness of from about 10µm to about 20µm.

The frit 150 is configured not to overlap with a metal wiring because the metal wiring may be damaged due to irradiation of a laser or an infrared ray. In certain embodiments, however, a portion of a metal wiring which is directly connected to a driver integrated circuit may underlie the frit 150

The supplement material 160 serves to prevent the organic light-emitting display device from being easily broken since the frit is formed from a brittle material. The supplement material 160 may also function as a sealing material if the frit 150 is not attached or its adhesive force is reduced since it is deliquesced with other materials.

The supplement material 160 is formed in at least one portion of outer surfaces of the first substrate, the second substrate and the frit. The supplement material may be formed by an immersing or dipping process. As will be described later, the supplement material may be selectively formed on the outer surfaces. Alternatively, the supplemental material may be formed on the substantially entire outer surfaces except a region in which a protective film is formed.

In the illustrated embodiment where the organic light-emitting display device is a top emission type, the supplement material 160 is formed on side surfaces of the substrate 100 and the encapsulation substrate 200, an outer side of the frit 150, and an outer surface of the base substrate 100. In another embodiment, a supplement material 160 may be formed by attaching the protective film 210 to a light emission region of the encapsulation substrate 200, and immersing the encapsulation substrate 200.

Similarly, the supplement material may be formed on side surfaces of the substrate and the encapsulation substrate, an outer side of the frit, and an outer surface of the encapsulation substrate if the organic light-emitting display device is a bottom emission type. The supplement material may be formed only on side surfaces of the substrate and the encapsulation substrate, an outer side of the frit, etc. if the organic light-emitting display device is a dual emission type.

In the illustrated embodiment, the supplement material 160 covers an internal driver integrated circuit (a data driving unit 170) while not covering external driver integrated circuits (scan driving units 180, 180'). However, it will be understood by those skilled in the art that the configuration of the supplement material 160 may be varied depending on its design.

The supplement material 160 may include a resin. The resin may be applied to the substrates in a liquid state. The resin may be cured by drying, heating, or UV, depending on the type of the resin. For example, cyanoacrylate may be cured by drying. Acrylate may be thermally cured at a temperature of about 30°C to about 80°C. Epoxy acrylate and urethane acrylate may be UV-cured. In one embodiment, a solution of the supplement material, used for forming a supplement material, has a viscosity of about 100 to about 4,000 cp.

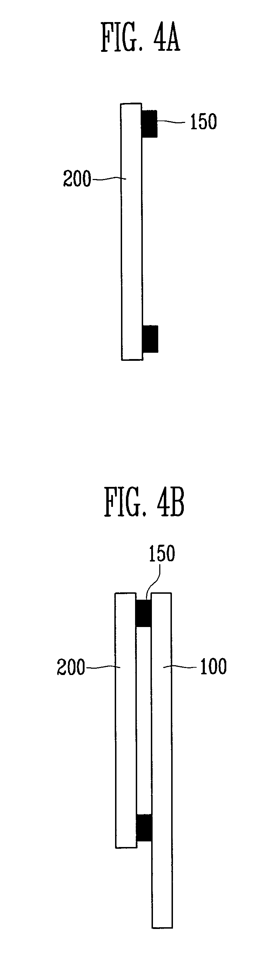

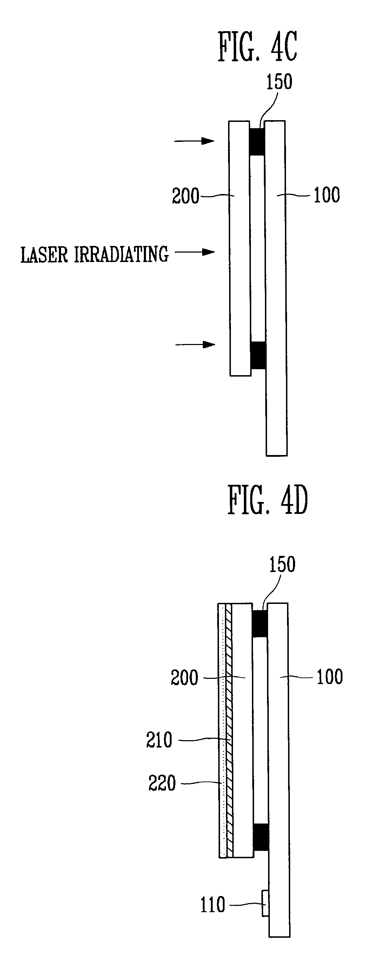

The aforementioned organic light-emitting display device may be prepared using various methods. One embodiment of a preparing method according to the invention will be described with reference to FIGs. 4a to 4h. FIGs. 4a to 4h are cross-sections showing a process for preparing an organic light-emitting display device. The illustrated organic light-emitting display device is a top emission type. A skilled artisan will appreciate that modifications and changes can be made in the case of a dual emission or a bottom emission type.

First, a frit 150 is applied in a linear shape to portions of an encapsulation substrate 200. The portions are spaced apart at a predetermined distance from an edge of the encapsulation substrate 200. The portions will face a non-pixel region 100a of the substrate 100, as will be described later. The frit 150 is applied to the encapsulation substrate 200 in the form of paste. Then, it is sintered to remove moisture and/or organic binders included in the paste, and then is cured. (FIG. 4A)

Next, a substrate 100 including a pixel region and a non-pixel region is prepared separately. The pixel region includes an organic light-emitting diode. The non-pixel region includes a driver integrated circuit and a metal wiring, etc. The encapsulation substrate 200 is placed over the substrate 100, covering the pixel region (FIG. 4B).

Next, a laser or an infrared ray irradiates the frit 150 between the substrate 100 and the encapsulation substrate 200 to melt the frit 150 between the substrate 100 and the encapsulation substrate 200. The irradiated laser or infrared ray used herein has a wavelength of about 800 to about 1,200 nm (optionally about 810 nm). Its power may range from about 25 to about 45 watts. The substantially entire portion of the outer surfaces of the substrates 100, 200, except the frit, may be masked. A bilayer of copper and aluminum may be used as materials of the mask. Then, the substrate 100 and the encapsulation substrate 200 are attached to each other by curing the melted frit 150 (FIG. 4C).

Next, a driver integrated circuit (Driver IC) may be attached to the substrate 100. A polarizer 210 is attached onto the outer surface of the encapsulation substrate 200. A protective film 220 is attached to the polarizer 210. The protective film 220 may be formed by applying an additional masking material. In other embodiments, a protective film 220 used for protecting the polarizer 210 itself may be used herein. The protective film 220 is prepared at a suitable size to cover at least the pixel region. Formation of the aforementioned protective film has been described with respect to a top emission type device. A protective layer may be formed on an opposite side in the case of a bottom emission type device, and a protective layer may be formed on both sides in the case of a dual emission type device.

One reason for forming the protective film 220 is to prevent a pixel region from being stained with a solution of the supplement material if the entire panel is immersed in the solution of the supplement material, as will be described later.

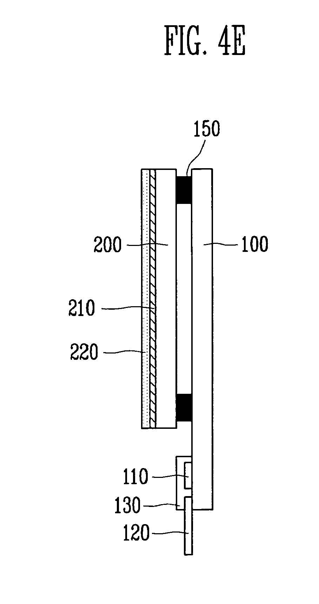

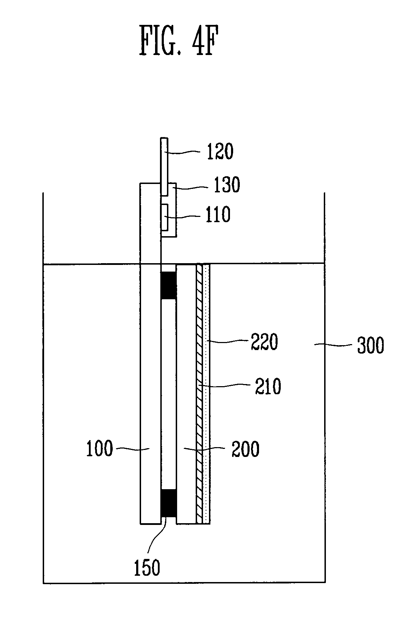

Next, a flexible printed circuit board 120, connected to a pad unit of the substrate 100 is attached, and then Tuppy for preventing oxidation of the pad unit is applied (FIG. 4E).

Next, the panel is immersed in a solution 300 of the supplement material. At least a pixel region of the panel is immersed to fill the solution 300 of the supplement material into a gap between the substrate and the encapsulation substrate 200, formed along an outer side of the frit 150 formed in an edge of the pixel region. The solution 300 of the supplement material is introduced into gaps by capillary action. (FIG. 4F)

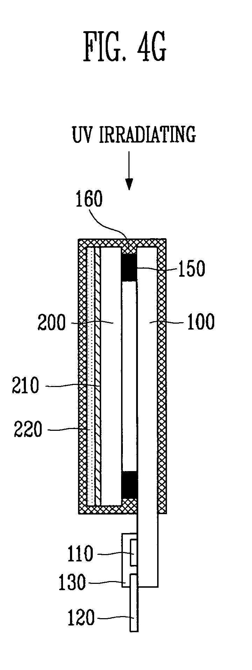

Next, the supplement material 160 is cured between the substrate 100 and the encapsulation substrate 200. In one embodiment, the supplement material 160 is masked and then is UV-irradiated if it is UV-curable. In another embodiment, the supplement material 160 is subjected to heating if it is thermally curable. If the supplement material 160 is cured by heat, then materials may be cured at a temperature of about 80°C or less to prevent thermal damages to an organic light-emitting diode. (FIG. 4G)

Next, the protective film 220 protecting an outer side of the panel is removed. Meanwhile, the solution of the supplement material (not shown) with which the substrate is stained may be used as an adhesive in a subsequent braket coalescing process. (FIG. 4H)

The invention has been described with reference to embodiments. However, it would be appreciated that modifications and changes might be made in these embodiments without departing from the principles of the invention. For example, the solution of the supplement material, the position of a protective film, and the order of forming a driver integrated circuit and a flexible printed circuit board may be changed.

According to the invention the substrate and the encapsulation substrate can solve a problem on brittleness of the organic light-emitting display device using the supplement material if they are used with the frit. Especially, the method according to the invention may be effectively used in a process where it is difficult to apply a supplement material.

Although embodiments of the invention have been shown and described, it would be appreciated by those skilled in the art that changes might be made in this embodiment without departing from the principles of the invention, the scope of which is defined in the claims and their equivalents.

## Claims

1. An organic light-emitting display device, comprising:
a first substrate comprising a first surface, an interior surface and side surfaces, wherein the first substrate is of a single layer or comprises a plurality of layers;
a second substrate comprising a second surface, an interior surface and side surfaces, the first substrate being placed over the second substrate, wherein the second substrate is of a single layer or comprises a plurality of layers;
an array of display pixels interposed between the first and second surfaces;
a frit seal formed between the interior surfaces of the first and second substrates while surrounding the array, wherein the frit seal, the first substrate and the second substrate in combination define an enclosed space in which the array is located, the frit seal comprising an outer surface facing away from the enclosed space; and
a resin layer formed on at least part of the second surface of the second substrate and on at least part of the side surfaces of the second substrate, the resin layer extending so as to contact the outer surface of the frit seal.

2. A device according to Claim 1, wherein the resin layer further extends to at least part of the side surfaces of the first substrate.

3. A device according to Claim 1, wherein the resin layer comprises a portion interposed between the first and second substrates.

4. A device according to Claim 3, wherein the portion contacts the interior surfaces of the first and second substrates.

5. A device according to any preceding claim, wherein the resin layer covers the substantially entire area of the second surface.

6. A device according to any preceding claim, wherein the resin layer covers the substantially entire area of the side surfaces of the second substrate.

7. A device according to any preceding claim, wherein the resin layer covers the substantially entire area of the outer surface of the frit seal.

8. A device according to any preceding claim, wherein the first substrate comprises a substantially transparent portion configured to pass visible light from the array, and wherein the resin layer further extends to the first surface while not covering the substantially transparent portion.

9. A device according to any preceding claim, wherein the resin layer comprises one or more materials selected from the group consisting of epoxy, acrylate and urethaneacrylate resins.

10. A device according to any of claims 1 to 4 or any one of claims 6 to 8 when dependent on any of claims 1 to 4, wherein the second substrate further comprises a non-overlapping portion over which the first substrate does not extend, and wherein at least part of the non-overlapping portion of the second substrate is substantially free of the resin layer.

11. A device according to Claim 10, wherein the device further comprises an array driving circuit formed over the non-overlapping portion of the second substrate, and wherein the resin layer does not extend to the array driving circuit.

12. A device according to any preceding claim, wherein the frit seal comprises one or more materials selected from the group consisting of magnesium oxide (MgO), calcium oxide (CaO), barium oxide (BaO), lithium oxide (Li₂O), sodium oxide (Na₂O), potassium oxide (K₂O), boron oxide (B₂O₃), vanadium oxide (V₂O₅), zinc oxide (ZnO), tellurium oxide (TeO₂), aluminum oxide (Al₂O₃), silicon dioxide (SiO₂), lead oxide (PbO), tin oxide (SnO), phosphorous oxide (P₂O₅), ruthenium oxide (Ru₂O), rubidium oxide (Rb₂O), rhodium oxide (Rh₂O), ferrite oxide (Fe₂O₃), copper oxide (CuO), titanium oxide (TiO₂), tungsten oxide (WO₃), bismuth oxide (Bi₂O₃), antimony oxide (Sb₂O₃), lead-borate glass, tin-phosphate glass, vanadate glass, and borosilicate.

13. A device according to any preceding claim, wherein the first substrate is a front substrate and the second substrate is a back substrate and wherein the first surface is a front surface and the second surface is a back surface.

14. A device according to one of claims 1 to 12, wherein the first substrate is a back substrate and the second substrate is a front substrate and wherein the first surface is a back surface and the second surface is a front surface.

15. A method of making an organic light-emitting display device, the method comprising:
providing a device comprising:
a first substrate comprising a first exterior surface, a first interior surface and first side surfaces,
a second substrate comprising a second exterior surface, a second interior surface and second side surfaces, the second substrate being placed over the first substrate,
an array of display pixels interposed between the first and second substrates, and
a frit seal formed between the first and second interior surfaces while surrounding the array, wherein the frit seal, the first substrate and the second substrate in combination define an enclosed space in which the array is located, the frit seal comprising an outer surface facing away from the enclosed space;
immersing the device into a resin solution;
removing the device from the resin solution, wherein the resin solution is coated on surfaces of the device after removing; and
curing the resin solution coated on the device so as to form a resin layer on surfaces of the device.

16. A method according to Claim 15, wherein the device further comprises an extension extending from the first substrate.

17. A method according to Claim 16; wherein when immersing, the device is substantially entirely immersed except the extension.

18. A method according to Claim 16 or 17, wherein the extension comprises a rod.

19. A method according to Claim 16 or 17, wherein the extension comprises a non-overlapping portion of the first substrate, over which the second substrate does not extend.

20. A method according to Claim 19, wherein when immersing, at least part of the non-overlapping portion is not immersed while the remainder of the device is substantially entirely immersed.

21. A method according to one of claims 15 to 20, wherein the resin solution has a viscosity of from 100 to 4,000cp.

22. A method according to one of claims 15 to 21, wherein the device further comprises a removable film over at least part of the second exterior surface, and wherein the resin solution is coated on the removable film after immersing and removing.

23. A method according to Claim 22, further comprising, after curing, removing the removable film and part of the resin layer formed on the removable film so as to expose at least part of the second exterior surface.
